# EUROPEAN PATENT SPECIFICATION

(11) **EP 0 704 976 B1**
(45) Date of publication and mention of the grant of the patent: **05.08.1998**
(21) Application number: 95306442.5
(22) Date of filing: 14.09.1995
(51) Int. Cl.: H03L 7/08, H03L 7/18

(54) **Phase-locked loop control circuit and method**
Verfahren und Schaltung zur Steuerung eines Phasenregelkreises
Méthode et circuit de contrôle d'une boucle à verrouillage de phase

(30) Priority: 23.09.1994 US 311469
(43) Date of publication of application: 03.04.1996
(73) Proprietor: Symbios, Inc., Fort Collins, Colorado 80525 (US)
(72) Inventor: Chen, Dao-Long, Fort Collins, CO 80525 (US)
(74) Representative: Gill, David Alan

(56) References cited:
- US-A- 5 175 512
- US-A- 5 258 725
- US-A- 5 302 920
- US-A- 5 331 295
- PATENT ABSTRACTS OF JAPAN vol. 18 no. 161 (E-1526) ,17 March 1994 & JP-A-05 335840 (FUJITSU LTD) 17 December 1993,

## Description

The present invention relates to a phase-locked loop control circuit and method.

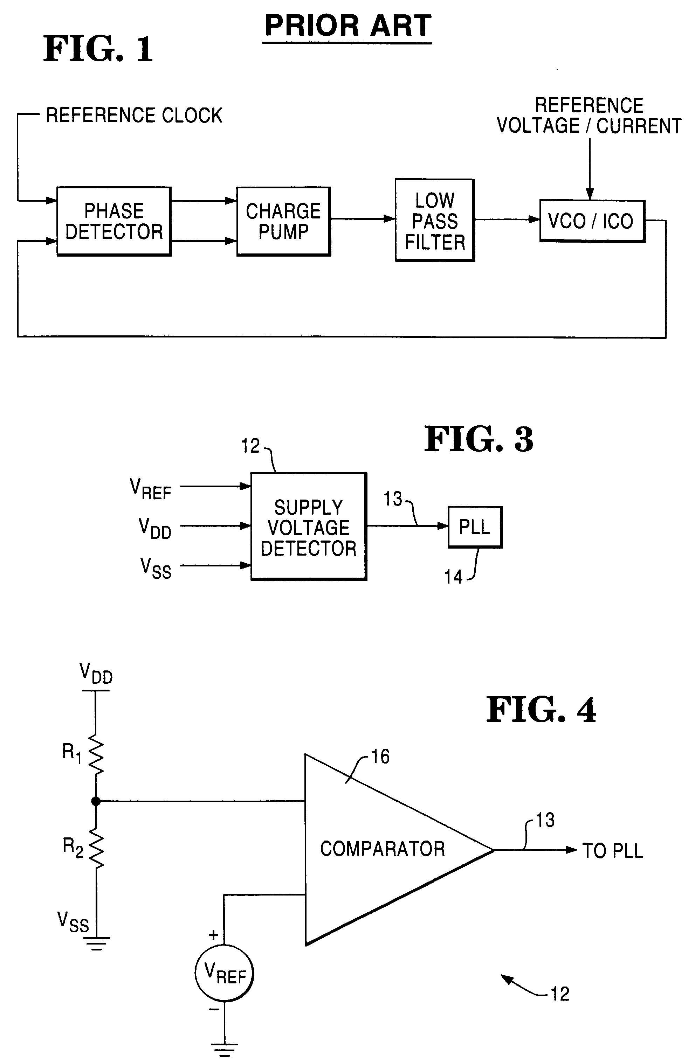

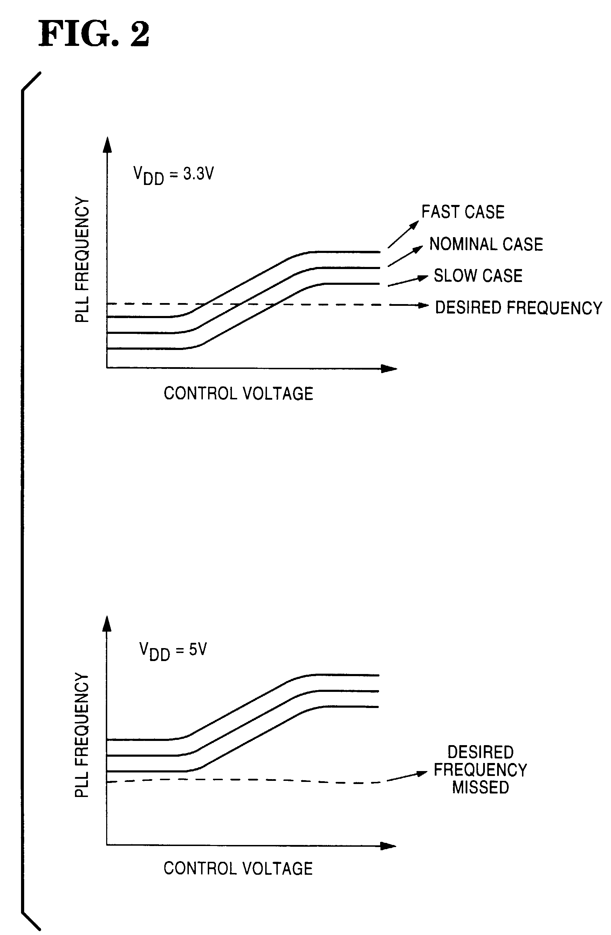

Until recently, most of the integrated circuits were designed to operate with a single 5V power supply voltage. But with the advent of portable PCS and energy efficient "green" PCS, many integrated circuits now have to be able to operate at both 3.3V and 5V. It is usually not a problem for digital circuits as long as the circuits can operate at the required clock frequency at 3.3V. But for analog circuits, operating at a different supply voltage can be a complicated issue, especially for the analog phase-locked loops (PLL). For example, the frequency range of a PLL usually has a strong dependency on the power supply voltage. Fig. 1 shows a typical PLL circuit known in the art. As shown in Fig. 2A-2B, a PLL designed for 3.3V operation can be too fast for 5V operation, especially if variations in temperature and process conditions are also taken into account. Similarly, a PLL designed to operate at 5V can be too slow if operated at 3.3V.

US-A-5 331 295 discloses a voltage controlled oscillator employed within a phase-locked loop in which a first current source provides a substantially constant current and in which a tracking current source provides a variable current that varies responsive to the supply voltage. The Patent Abstract of JP-A-05-335840 discloses a method of controlling the operation of a phase-locked loop in which a supply voltage is detected and a particular bias circuit selected responsive to the detected supply voltage. Further, US-A-5 175 512 discloses a method of controlling the operation of a phase-locked loop in which an independent bias circuit is employed for generating a bias voltage and in which the voltage controlled oscillator operating frequency is adjusted responsive to a voltage which itself is responsive to the bias voltage generated by the bias circuit. Finally, US-A-5 258 725 discloses a method of controlling the operation of a phase-locked loop involving the steps of detecting a supply voltage and adjusting the operating frequency of the phase-locked loop responsive to the detected supply voltage.

However, the known arrangements identified above are disadvantageously limited insofar as the operating frequency of the phase-locked loop is controlled.

The present invention seeks to provide for a phase-locked loop control circuit and method which overcomes the above disadvantages.

According to one aspect of the present invention there is provided a method of controlling the operation of a phase-locked loop comprising the steps of detecting a supply voltage and adjusting the operating frequency of the phase-locked loop in response to the detected supply voltage, and characterised in that the frequency range of the phase-locked loop is adjusted by enabling or disabling at least one frequency divider in the phase-locked loop based upon the detected supply voltage.

According to another aspect of the present invention there is provided phased-locked loop control means comprising means for detecting a supply voltage of said phase-locked loop, means for adjusting the operating frequency of the phase-locked loop in response to the detected supply voltage, characterised in that said means for adjusting the operating frequency of the phase-locked loop (14) comprises means (28) for selectively enabling at least one frequency divider (26) in the phase-locked loop (14) based upon the detected supply voltage.

The present invention advantageously provides a method for adjusting the frequency range of a phase-locked loop based on a supply voltage so that the same phase-locked loop design can operate at different supply voltages.

Further the present invention can provide for a phase-locked loop that can operate at both 3.3V and 5V.

A phase-locked loop design is provided that can operate at a plurality of dissimilar supply voltages. By adjusting the frequency range of the phase-locked loop based on the power supply voltage, the same phase-locked loop design can operate at different supply voltages.

The invention is described further hereinafter, by way of example only, with reference to the accompanying drawings in which:
Fig. 3 is a block diagram of an improved phase-locked loop;
Fig. 4 is a schematic of a supply voltage detector circuit;
Fig. 5 is a detailed block diagram of an improved phase-locked loop;
Fig. 6 is a schematic for changing the reference voltage/current of a PLL using a voltage to current converter;
Fig. 7 is a schematic for changing the reference voltage/current of a PLL using a voltage to current converter, and including supply voltage detection circuitry;
Fig. 8 is a schematic for changing the reference voltage/current of a PLL using a linear current source, and including supply voltage detection circuitry; and
Fig. 9 is a schematic for changing the reference voltage/current of a PLL using a linear current source.

Fig. 3 shows how to adjust the frequency range of a PLL based on supply voltage. First, the power supply voltage level is detected by detector 12. The detector output 13 is coupled to the PLL 14. Supply voltage detector 12 operates by comparing the supply voltage VDD with a reference voltage VREF which is independent of the supply voltage. The reference voltage VREF can come from an external voltage regulator or be generated on-chip by a bandgap reference voltage source. Since the reference voltage VREF will generally be lower than the supply voltage VDD, the reference voltage cannot be compared directly with the supply voltage. Rather, the supply voltage is scaled and compared with the reference voltage. There are many possible ways to scale down the supply voltage. One way is to use a voltage divider as shown in Fig. 4. If all that is needed is to operate the PLL at 3.3V and 5V, a divide-by-two voltage divider R1/R2 is used to scale the supply voltage VDD from 3.3V to 1.65V and from 5V to 2.5V. For an equal margin on both sides, a 2.075V reference voltage VREF is used to detect the supply voltage.

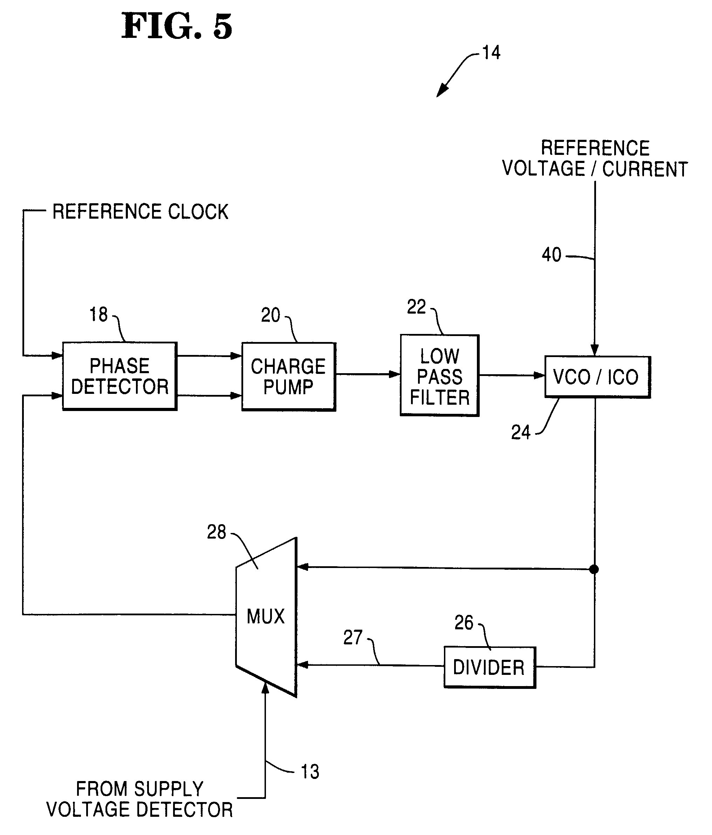

Once the supply voltage level is detected, the next step is to find a way to adjust the PLL frequency range accordingly. A possible solution is to insert a frequency divider which can be enabled when operated at 5V to divide down the PLL output frequency. Fig. 5 shows a phase-locked loop 14 comprising a phase detector 18, charge pump 20, low pass filter 22 and VCO/ICO 24. However, as also shown in Fig. 5, the PLL has been modified to include a frequency divider 26 between the VCO/ICO 24 and the phase detector 18. The output 27 from the frequency divider 26 is selected by the multiplexer 28 if a 5V supply voltage is detected, as indicated by control line 13 (which may be generated by the circuit shown in Fig. 4).

However, there are a few drawbacks associated with this approach. First of all, the frequency divider 26 requires extra silicon area and consumes extra power at relatively high frequency. Secondly, if a non-integer divider is required, this feature can prove difficult to implement. An easier way to adjust the PLL frequency range is to adjust the reference voltage or current 40 that goes into the PLL. Most of the VCO (Voltage-Controlled Oscillator) or ICO (Current-Controlled Oscillator) based PLLs have either an external voltage or current source that determines the PLL's center operating frequency, one such oscillator being described in U.S. patent 5,302,920 entitled "Controllable Multi-Phase Ring Oscillators with Variable Current Sources and Capacitances". By changing the reference voltage or current 40, the PLL frequency range can be adjusted based on the detected supply voltage.

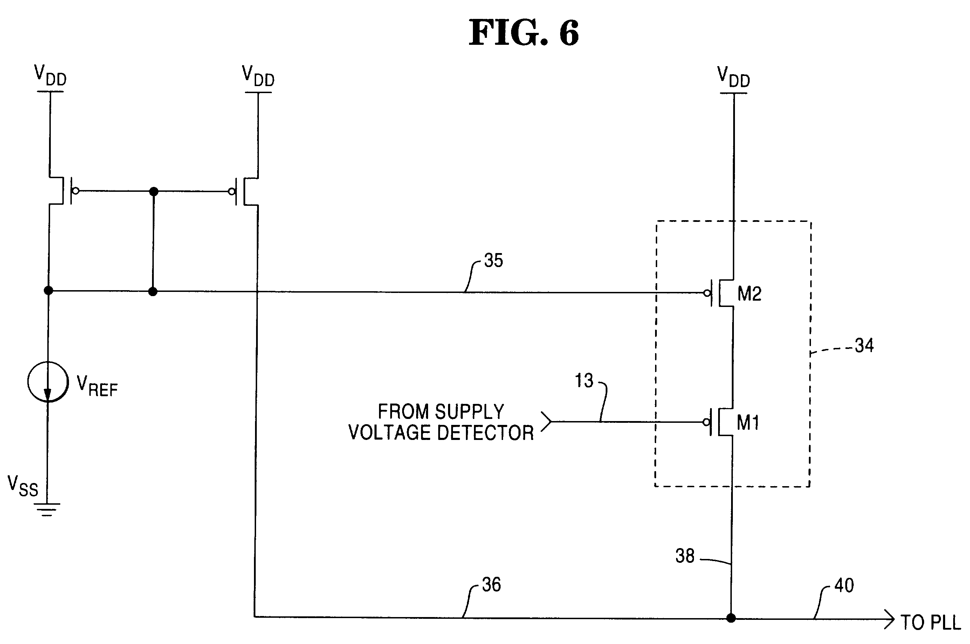

Fig. 6 gives an example on how this can be done by adding two transistors M1 and M2, which function as a voltage to current (V-I) converter 34. The reference current going into the PLL at 40, which is the sum of current source output 36 and V-I converter output 38, is reduced by turning off the transistor M1 when a 5V power supply voltage is detected, as indicated by control line 13. If a 3.3V power supply voltage is detected, transistor M1 is turned on, and supplies additional current to the PLL via output 38 to PLL input 40.

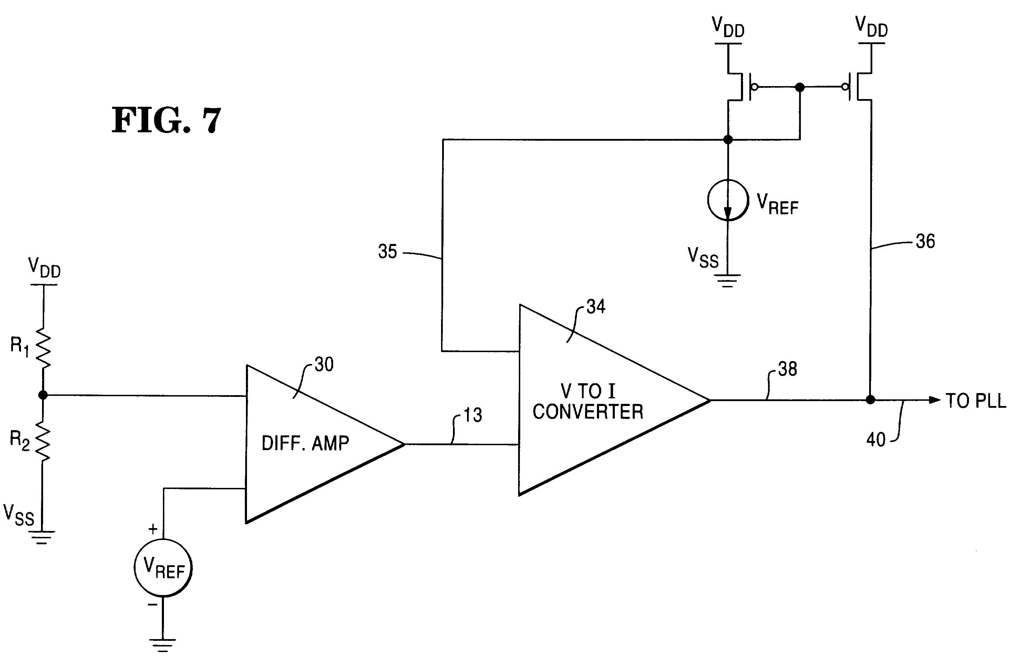

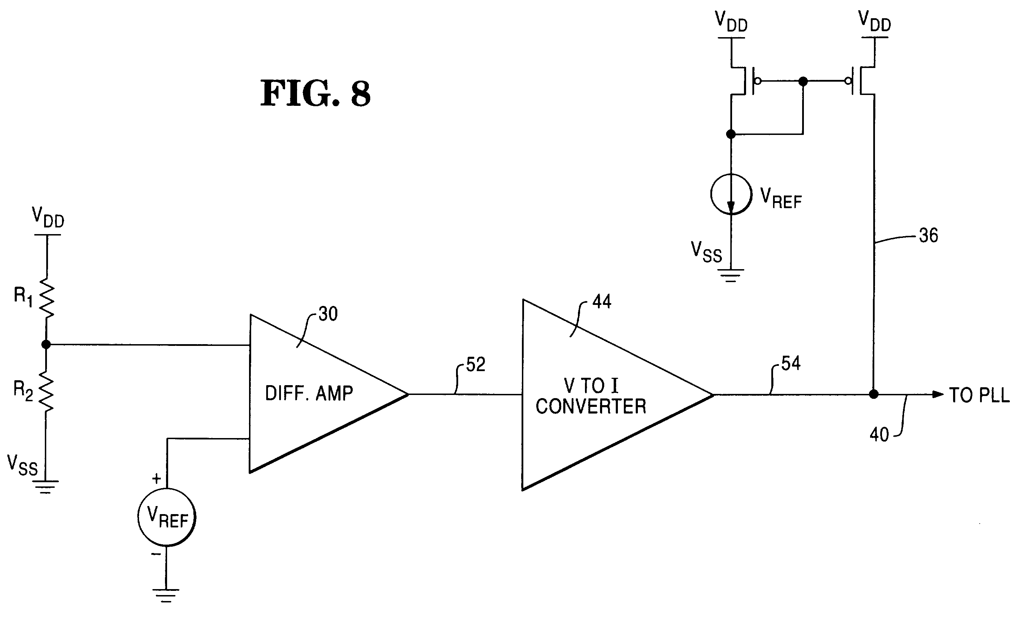

Fig. 7 shows how to operate the PLL at both 3.3V and 5V. It is even better if the frequency range could be adjusted linearly with the supply voltage so that the PLL could operate at any supply voltage level. This is done by replacing the comparator 16 of Fig. 4 with a differential amplifier, as shown at 30 in Fig. 8. The output 52 of the differential amplifier is proportional to the difference between the supply-independent reference voltage VREF and the scaled supply voltage VDD. This output voltage 52 is then used to adjust the reference voltage/current going into the PLL, similar to the technique that was previously described with respect to Fig. 6. However, since the differential amplifier provides an analog output voltage (as opposed to a digital output from the comparator of Fig. 7), a simplified voltage to current converter 44 is used.

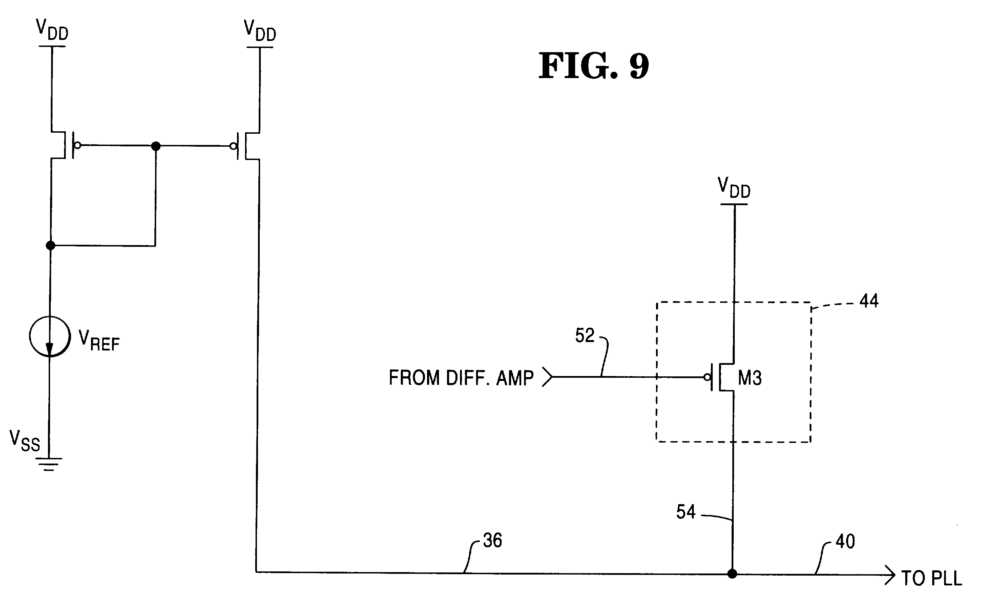

As shown in Fig. 9, the simplified voltage to current converter only requires a single transistor M3, which is biased by the output voltage 52 from the differential amplifier 30.

The circuit of Fig. 8 thus provides a technique for adjusting the reference current linearly with the supply voltage, such that the PLL can operate at a plurality of dissimilar supply voltages.

It should be appreciated that the present invention is not restricted to the details of the foregoing embodiments.

## Claims

1. A method of controlling the operation of a phase-locked loop (14) comprising the steps of detecting a supply voltage and adjusting the operating frequency of the phase-locked loop (14) in response to the detected supply voltage, and characterised in that the frequency range of the phase-locked loop is adjusted by enabling or disabling at least one frequency divider (26) in the phase-locked loop (14) based upon the detected supply voltage.

2. A method as claimed in Claim 1, wherein the operation of the phase-locked loop (14) is controlled by adjusting the frequency range of the phase-locked loop by adjusting a phase-locked loop reference voltage or current based upon the detected supply voltage.

3. Phase-locked loop control means comprising means (12) for detecting a supply voltage of said phase-locked loop (14), means (26,34,44) for adjusting the operating frequency of the phase-locked loop (14) in response to the detected supply voltage, characterised in that said means for adjusting the operating frequency of the phase-locked loop (14) comprises means (28) for selectively enabling at least one frequency divider (26) in the phase-locked loop (14) based upon the detected supply voltage.

4. Phase-locked loop control means as claimed in Claim 3, wherein said means for adjusting the operating frequency of the phase-locked loop (14) comprises means (34,44) for adjusting a phase-locked loop reference voltage or current based upon the detected supply voltage.

5. A phase-locked loop circuit (14) having control means as claimed in Claim 3 and having an oscillator (24) and at least one current source which adjusts the reference operating point of said oscillator (24) based upon said supply voltage.

6. A phase-locked loop circuit (14) having control means as claimed in Claim 3 and having a phase detector (18) operatively coupled to a charge pump (20), a filter (22) operatively coupled to said charge pump (20), an oscillator (24) operatively coupled to said filter (22), and having a reference operating point, and adjusting means for dynamically adjusting the reference operating point based upon the supply voltage.

7. A circuit as claimed in Claim 6, wherein the adjusting means comprises a plurality of current sources (36,38;36,54).

8. A circuit as claimed in Claim 7, further comprising means (M1;M3) for selectively enabling at least one of the plurality of current sources (36,38;36,54).

9. Phase-locked loop control means as claimed in Claim 3, comprising a differential amplifier (30) having a reference voltage input and a scaled supply voltage input, a linear current source (54) having at least one input coupled to an output (52) of the differential amplifier (30), and a fixed current source (36) coupled to an output of the linear current source (54).

## Patentansprüche

1. Verfahren zum Steuern des Betriebs eines Phasenregelkreises (14), umfassend die folgenden Schritte: Erfassen einer Versorgungsspannung und Einstellen der Betriebsfrequenz des Phasenregelkreises (14) in Reaktion auf die erfaßte Versorgungsspannung, und dadurch gekennzeichnet, daß der Frequenzbereich des Phasenregelkreises durch Aktivieren oder Deaktivieren von wenigstens einem Frequenzteiler (26) im Phasenregelkreis auf der Basis der erfaßten Versorgungsspannung eingestellt wird.

2. Verfahren nach Anspruch 1, bei dem der Betrieb des Phasenregelkreises (14) durch Einstellen des Frequenzbereiches des Phasenregelkreises durch Einstellen einer/eines Phasenregelkreis-Bezugsspannung oder -stroms auf der Basis der erfaßten Versorgungsspannung geregelt wird.

3. Phasenregelkreis-Steuermittel, umfassend ein Mittel (12) zum Erfassen einer Versorgungsspannung des genannten Phasenregelkreises (14), ein Mittel (26, 34, 44) zum Einstellen der Betriebsfrequenz des Phasenregelkreises (14) in Reaktion auf die erfaßte Versorgungsspannung, dadurch gekennzeichnet, daß das genannte Mittel zum Einstellen der Betriebsfrequenz des Phasenregelkreises (14) ein Mittel (28) umfaßt, um wenigstens einen Frequenzteiler (26) im Phasenregelkreis (14) auf der Basis der erfaßten Versorgungsspannung selektiv zu aktivieren.

4. Phasenregelkreis-Steuermittel nach Anspruch 3, bei dem das genannte Mittel zum Einstellen der Betriebsfrequenz des Phasenregelkreises (14) ein Mittel (34, 44) zum Einstellen einer/eines Phasenregelkreis-Bezugsspannung oder -stroms auf der Basis der erfaßten Versorgungsspannung umfaßt.

5. Phasenregelkreisschaltung (14) mit einem Steuermittel nach Anspruch 3 und mit einem Oszillator (24) und mit wenigstens einer Stromquelle, die den Bezugsbetriebspunkt des genannten Oszillators (24) auf der Basis der genannten Versorgungsspannung einstellt.

6. Phasenregelkreisschaltung (14) mit einem Steuermittel nach Anspruch 3 und einem Phasendetektor (18), der betriebsmäßig mit einer Ladungspumpe (20) gekoppelt ist, einem mit der genannten Ladungspumpe (20) betriebsmäßig gekoppelten Filter (22), einem mit dem genannten Filter (22) betriebsmäßig gekoppelten Oszillator (24) und mit einem Bezugsbetriebspunkt und einem Einstellmittel zum dynamischen Einstellen des Referenzbetriebspunktes auf der Basis der Versorgungsspannung.

7. Schaltung nach Anspruch 6, bei der das Einstellmittel eine Mehrzahl von Stromquellen (36, 38; 36, 54) umfaßt.

8. Schaltung nach Anspruch 7, ferner umfassend ein Mittel (M1; M3) zum selektiven Aktivieren von wenigstens einer aus der Mehrzahl von Stromquellen (36, 38; 36, 54).

9. Phasenregelkreissteuermittel nach Anspruch 3, umfassend einen Differentialverstärker (30) mit einem Bezugsspannungseingang und einem skalierten Versorgungsspannungseingang, wobei eine lineare Stromquelle (54) wenigstens einen Eingang aufweist, der mit einem Ausgang (52) des Differentialverstärkers (30) gekoppelt ist, und eine feste Stromquelle (36), die mit einem Ausgang der linearen Stromquelle (54) gekoppelt ist.

## Revendications

1. Procédé pour commander le fonctionnement d'une boucle à phase asservie (14) comprenant les étapes consistant à détecter une tension d'alimentation et à ajuster la fréquence d'oscillation de la boucle à phase asservie (14) en réponse à la tension d'alimentation détectée, et caractérisé en ce que la plage de fréquence de la boucle à phase asservie est ajustée en activant ou en désactivant au moins un diviseur de fréquence (26) dans la boucle à phase asservie (14) sur la base de la tension d'alimentation détectée.

2. Procédé selon la revendication 1, dans lequel le fonctionnement de la boucle à phase asservie (14) est commandé en ajustant la plage de fréquence de la boucle à phase asservie en ajustant une tension ou un courant de référence de la boucle à phase asservie sur la base de la tension d'alimentation détectée.

3. Moyens de commande de boucle à phase asservie comprenant des moyens (12) pour détecter une tension d'alimentation de ladite boucle à phase asservie (14), des moyens (26, 34, 44) pour ajuster la fréquence d'oscillation de la boucle à phase asservie (14) en réponse à la tension d'alimentation détectée, caractérisé en ce que lesdits moyens pour ajuster la fréquence d'oscillation de la boucle à phase asservie (14) comprennent des moyens (28) pour activer sélectivement au moins un diviseur de fréquence (26) dans la boucle à phase asservie (14) sur la base de la tension d'alimentation détectée.

4. Moyens de commande de boucle à phase asservie selon la revendication 3, dans lequel lesdits moyens pour ajuster la fréquence d'oscillation de la boucle à phase asservie (14) comprennent des moyens (34, 44) pour ajuster une tension ou un courant de référence de la boucle à phase asservie sur la base de la tension d'alimentation détectée.

5. Circuit à asservissement de phase (14) ayant des moyens de commande selon la revendication 3 et ayant un oscillateur (24) et au moins une source de courant qui ajuste le point d'oscillation de référence dudit oscillateur (24) sur la base de ladite tension d'alimentation.

6. Circuit en boucle à phase asservie (14) ayant des moyens de commande selon la revendication 3 et ayant un détecteur de phase (18) couplé de manière fonctionnelle à une pompe à charge (20), un filtre (22) couplé de manière fonctionnelle à ladite pompe à charge (20), un oscillateur (24) couplé de manière fonctionnelle audit filtre (22), et ayant un point d'oscillation de référence, et des moyens d'ajustement destinés à ajuster dynamiquement le point d'oscillation de référence sur la base de la tension d'alimentation.

7. Circuit selon la revendication 6, dans lequel les moyens d'ajustement comprennent une pluralité de sources de courant (36, 38 ; 36, 54).

8. Circuit selon la revendication 7, comprenant en outre des moyens (M1 ; M3) destinés à activer sélectivement au moins une source d'une pluralité de sources de courant (36, 38 ; 36, 54).

9. Moyens de commande de boucle à phase asservie selon la revendication 3, comprenant un amplificateur différentiel (30) ayant une entrée de tension de référence et une entrée de tension d'alimentation mise à l'échelle, une source de courant linéaire (54) ayant au moins une entrée couplée à une sortie (52) de l'amplificateur différentiel (30), et une source de courant fixe (36) couplée à une sortie de la source de courant linéaire (54).
